Europäisches Patentamt

European Patent Office

Office européen des brevets

(19)

(11) EP 0 797 303 A2

(12) **EUROPEAN PATENT APPLICATION**

(43) Date of publication:
24.09.1997 Bulletin 1997/39

(51) Int. Cl.$^6$: **H03K 19/0185**, H03F 3/347

(21) Application number: 97104420.1

(22) Date of filing: 14.03.1997

(84) Designated Contracting States:
DE FR GB

(30) Priority: 19.03.1996 JP 62536/96

(71) Applicant: SHARP KABUSHIKI KAISHA
Osaka 545 (JP)

(72) Inventor: Iizuka, Kunihiko
Sakai-shi, Osaka 591 (JP)

(74) Representative: Müller, Frithjof E., Dipl.-Ing.
Patentanwälte
MÜLLER & HOFFMANN,
Innere Wiener Strasse 17
81667 München (DE)

(54) **Inverter circuit and amplifier**

(57) An inverter circuit is composed of a first inverter section used as an amplifier and a second inverter section, connected in series to the first inverter section, for controlling the gain of the first inverter section. Each of the first and second inverter sections includes a P type MOS field effect transistor and an N type MOS field effect transistor. The P type transistors are similar to each other, and so are the N type transistors. For example, the transistors in the second inverter section have a proportion (ratio of the channel width to the channel length) 1/A time that of the respective transistors in the first inverter section, where "A" is a positive constant. Input and output terminals of the second inverter section are short-circuited. In other words, the transistors of the second inverter section are connected at their gates and drains, thus replacing conventional resistors. If the positive constant A is set to be smaller than the DC gain of a typical inverter, the DC gain of the inverter arranged as above is not affected by irregularity in a manufacturing process and can be regarded equal to A. This prevents the parasitic capacity from increasing with an increase of the area. Therefore, it is possible to restrain deterioration of the frequency characteristics and power consumption.

FIG.1

EP 0 797 303 A2

## Description

FIELD OF THE INVENTION

The present invention relates to an inverter circuit and an amplifier incorporating CMOS field effect transistors.

BACKGROUND OF THE INVENTION

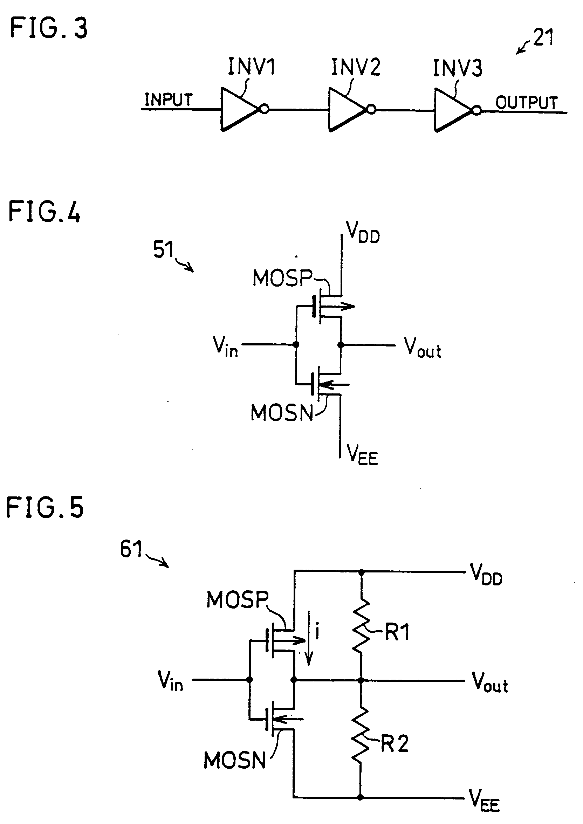

As shown in Fig. 4, an inverter circuit 51 using conventional CMOSFETs are composed of a P type field effect transistor (MOSP) and an N type field effect transistor (MOSN). Various applications of such an inverter circuit 51 as a basic circuit for an analog signal processing circuit and for an analog operation circuit are considered in recent years. For example, Japanese Laid-Open Patent Application No. 6-215164/1994 (Tokukaihei 6-215164) discloses a technology for applying the inverter circuit 51 to a multiplication circuit. "IEEE J. Solid-State Circuits, p. 1552-1559, vol. 29, No. 12, 1994" discloses a technology for applying the inverter circuit 51 to an infrared ray communication receiver. Other possible applications include a sample hold circuit for analog voltage, a scaler circuit, an addition circuit and a filter circuit.

The DC gain G of the inverter circuit 51 is given by Eq. (1):

$$G = - \frac{(g_{mN} - g_{mP})}{(g_{dN} - g_{dP})} \tag{1}$$

$$= - \frac{2 \cdot (\frac{1}{(V_M - V_{thN})} + \frac{1}{(V_M + V_{thP})})}{\lambda_N - \lambda_P}$$

where

$$V_M = \frac{V_{DD} - V_{EE}}{2} \tag{2},$$

$g_{mP}$ and $g_{mN}$ are the transconductance of a P type field effect transistor (MOSP) and the transconductance of an N type field effect transistor (MOSN) respectively, $g_{dP}$ and $g_{dN}$ are the drain conductance of the P type field effect transistor (MOSP) and the drain conductance of the N type field effect transistor (MOSN) respectively, $V_{thP}$ and $V_{thN}$ are the threshold voltage of the P type field effect transistor (MOSP) and the threshold voltage of the N type field effect transistor (MOSN) respectively, and $\lambda_P$ and $\lambda_N$ are the channel length conversion coefficient of the P type field effect transistor (MOSP) and the channel length conversion coefficient of the N type field effect transistor (MOSN) respectively.

The absolute value |G| of the DC gain G of the inverter circuit 51 is, typically, approximately between 10 and 30. When a negative feedback is applied to an amplifier circuit composed of a plurality of such inverter circuits 51 connected in series, it is necessary to reduce the gain of the inverter circuits 51 in order to improve frequency characteristics.

Therefore, conventionally, as the inverter circuit 61 shown in Fig. 5, resistors R1 and R2 are provided between an output terminal and a power source voltage $V_{DD}$ and between the output terminal and a power source voltage $V_{EE}$ respectively, so as to reduce the output resistance and, thereby, reduce the gain. The DC gain G of the inverter circuit 61 in Fig. 5 is given by Eq. (3):

$$G = - \frac{(g_{mN} - g_{mP})}{(g_{dN} - g_{dP} + \frac{1}{R1} + \frac{1}{R2})} \tag{3}$$

$$= - \frac{2 \cdot i \cdot (\frac{1}{(V_M - V_{thN})} + \frac{1}{(V_M + V_{thP})})}{i \cdot (\lambda_N - \lambda_P) + \frac{1}{R1} + \frac{1}{R2}}$$

where "i" is an electric current through the drain and the source of the P type filed effect transistor (MOSP).

However, these conventional technologies have problems: the gain G varies due to resistance variations caused by irregularity in manufacture, the frequency characteristics deteriorate due to an increase of the parasitic capacity resulting from an increase of the area, and the power consumption is increased. That is, typical problems of the circuit in Fig.

formed as part of an integrated circuit are:

- The resistances of the resistors R1 and R2 are not as precise as they should be, and therefore G differs from its designed value.
- $g_{mN}$, $g_{mP}$ $g_{dN}$ and $g_{dP}$ vary because of irregularity in a manufacturing process, and the DC gain G therefore differs from its designed value.
- The resistors R1 and R2 have large areas and inevitably create large parasitic capacities, causing deterioration of the frequency characteristics.
- The power consumption increases due to the current through the resistors R1 and R2.

SUMMARY OF THE INVENTION

An object of the present invention is to offer an inverter circuit and an amplifier little affected by irregularity in manufacture, producing a small parasitic capacity, and consuming a little power.

In order to accomplish the object, an inverter circuit in accordance with the present invention is characterized in that it includes:

a first inverter section including a first CMOS inverter composed of P type and N type field effect transistors connected in a CMOS structure; and

a second inverter section including a second CMOS inverter and being connected in series to an output terminal of the first inverter section, the second CMOS inverter being of a similar size to the first CMOS inverter and being short-circuited between an input terminal thereof and an output terminal thereof.

With the arrangement, (i) the second inverter section operates equivalently to a resistor connected to an output terminal of the first inverter section, thereby reducing the gain of the first inverter section to a desired value, (ii) the first and second CMOS inverters, being of similar sizes to each other, allow the first and second inverter sections to change the characteristics thereof in the same tendency when there is irregularity in a manufacturing process of a large scale integrated (LSI) circuit, (iii) the sizes of both the CMOS inverters can be easily controlled by controlling the gate length and width of the field effect transistors composing the CMOS inverters. Consequently, an inverter circuit with a DC gain very close to a designed value can be made in an integrated circuit, regardless of possible irregularity in a manufacturing process of an LSI.

Such an inverter circuit has advantages, in comparison with a conventional inverter circuit using resistors for controlling the gain. For example, the inverter circuit (i) occupies a smaller area, because the field effect transistors are used instead of the resistors, (ii) has better frequency characteristics, because the parasitic capacity is reduced, and (iii) consumes less power, because the second inverter section has a CMOS structure which allows no electric current to flow as long as there is no change in the output.

For a more precise control of the gain of the inverter circuit, the field effect transistors composing the first and second CMOS inverters are preferably field effect transistors of a unit size.

With the arrangement, since the field effect transistors are composed in a unit size, the field effect transistors composing the first inverter section have the same physical property parameters (e.g., the channel length conversion coefficient and threshold voltage) as those composing the second inverter section. As a result, the irregularity of the gain of the inverter circuit caused by irregularity in a manufacturing process can be more reduced than in a case where the field effect transistors composing the first and second inverter sections are similar with a ratio of similitude not equal to 1.

Incidentally, when each of the first and second inverter sections is composed of a single MOS inverter, constraints in a manufacturing process limit the gain of the first inverter section and the size ratio (ratio of similitude) of the field effect transistors of both the inverter sections. Therefore, the gain and precision of the inverter circuit may not be set as desired. Especially, when the ratio of similitude equals 1, the gain of the inverter circuit is limited to approximately 1.

If none of the above arrangements can produce a desired gain and precision, at least one of the first and second inverter sections preferably includes a plurality of first or second CMOS inverters parallelly connected to each other.

With the arrangement, the gain of the inverter circuit is controlled with the ratio of the number of the first CMOS inverters composing the first inverter section and the number of the second CMOS inverters composing the second inverter section. Therefore, the gain can be controlled to have a value which is difficult to realize due to constraints in a manufacturing process if each of the first and second inverter sections is composed of a single CMOS inverter.

The arrangement is especially effective when both the CMOS inverters are composed of field effect transistors of a unit size. To be specific, this arrangement can more freely set the gain of the inverter circuit than the inverter sections composed of a single inverter, and can more precisely control the gain of the inverter circuit than in a case where the ratio of similitude is set to a value other than 1.

Incidentally, a typical preferred application example of the inverter circuit is an amplifier composed of a plurality of the inverter circuits connected in series. In this case, at least one of the inverter circuits composing the amplifier is preferably an inverter circuit having one of the above arrangements (hereinafter, will be referred to as a special inverter circuit).

With the arrangement, the gain of the amplifier equals the product of the gains of the inverter circuits. Therefore, an amplifier with a very large gain which is difficult to realize with a single inverter circuit can be easily made. Moreover, since at least one of the inverter circuits includes the second inverter section for controlling the gain, the gain of such an amplifier can be more precisely set than that of a conventional amplifier.

The special inverter circuit operates effectively when applied in an amplifier composed of an odd number of the inverter circuits connected in series to each other. The arrangement forms an inversion amplifier. With the arrangement, since at least one of the inverter circuits is a special inverter circuit, the gain of the inversion amplifier can be precisely controlled. Therefore, when an output of the inversion amplifier is fed back negatively to an input, the gain of the inversion amplifier can be set so as to be the largest in a range where a stable feedback is possible. As a result, the frequency characteristics of the inversion amplifier can be effectively improved.

For a fuller understanding of the nature and advantages of the invention, reference should be made to the ensuing detailed description taken in conjunction with the accompanying drawings.

## BRIEF DESCRIPTION OF THE DRAWINGS

Fig. 1 is a circuit diagram showing an embodiment of an inverter circuit in accordance with the present invention.

Fig. 2 is a circuit diagram showing another embodiment of an inverter circuit in accordance with the present invention.

Fig. 3 is a circuit diagram showing an embodiment of an amplifier in accordance with the present invention.

Fig. 4 is a circuit diagram showing a conventional inverter circuit.

Fig. 5, another conventional example, is a circuit diagram showing an inverter circuit.

## DESCRIPTION OF THE EMBODIMENTS

### [FIRST EMBODIMENT]

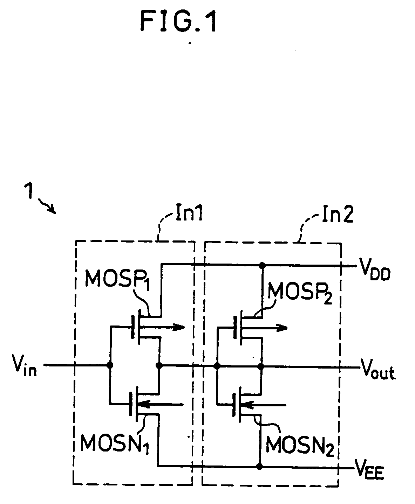

Referring to Fig. 1, the following description will explain a first embodiment of an inverter circuit.

As shown in Fig. 1, an inverter circuit 1 of the present embodiment is composed of an inverter section In1 used as an amplifier and an inverter section In2, connected in series to the inverter section In1, for controlling the gain of the inverter section In1. More specifically, the inverter sections In1 and In2 are inverters of a complementary metal oxide semiconductor (CMOS) structure. The inverter section In1 includes a P type MOS field effect transistor ($MOSP_1$) and an N type MOS field effect transistor ($MOSN_1$), whereas the inverter section In2 includes a P type MOS field effect transistor ($MOSP_2$) and an N type MOS field effect transistor ($MOSN_2$). In the inverter section In1, the gates of the transistor $MOSP_1$ and of the transistor $MOSN_1$ are connected to each other to form an input terminal to which an input voltage $V_{in}$ is applied. The drains of the transistors $MOSP_1$ and $MOSN_1$ are connected to each other, and further connected to the gates of the transistors $MOSP_2$ and $MOSN_2$ that form an input terminal of the inverter section In2. In the inverter section In2, the drains of the transistors $MOSP_2$ and $MOSN_2$ are connected to each other to form an output terminal from which an output voltage $V_{OUT}$ of the inverter circuit 1 is outputted. A power source voltage $V_{DD}$ is applied to the sources of the transistors $MOSP_1$ and $MOSP_2$, whereas a power source voltage $V_{EE}$ is applied to the sources of the transistors $MOSN_1$ and $MOSN_2$.

The inverter section In2 is similar to the inverter section In1. That is, the proportion (the ratio of the channel width to the channel length) of the P type MOS field effect transistor $MOSP_2$ is 1/A time that of the P type MOS field effect transistor $MOSP_1$, whereas the proportion (the ratio of the channel width to the channel length) of the N type MOS field effect transistor $MOSN_2$ is also 1/A time that of the N type MOS field effect transistor $MOSN_1$.

Moreover, the input and output terminals of the inverter section In2 are short-circuited. Specifically, in the inverter section In2, the drains of the P type MOS field effect transistor $MOSP_2$ and of the N type MOS field effect transistor $MOSN_2$ are connected to the respective gates. In this manner, the transistors $MOSP_2$ and $MOSN_2$ form an equivalent resistor to the resistors R1 and R2 shown in Fig. 5 in a small signal operation. The resistor R1 is connected to the output terminal and the power source voltage $V_{DD}$, whereas the resistor R2 is disposed between the output terminal and the power source voltage $V_{EE}$. Note that both the inverter sections In1 and In2 here are described to include only one inverter as an example.

When a positive constant A is smaller than the absolute value of the DC gain of a typical inverter, the absolute value of the DC gain G of the inverter circuit 1 arranged as above is not affected by irregularity in a manufacturing process and approximately equals A. In addition, the area required for the circuit, the parasitic capacity and the power consumption can be reduced, compared with a case where the gain is controlled with resistors (see Fig. 5).

To be specific, the DC gain G of the inverter circuit 1 formed by the circuit shown in Fig. 1 is given by Eq. (4):

$$G = - \frac{g_{mN1} \cdot g_{mP1}}{(g_{dN1} \cdot g_{dP1}) + (g_{mN2} \cdot g_{mP2}) + (g_{dN2} \cdot g_{dP2})} \tag{4}$$

where $g_{mN1}$, $g_{mN2}$, $g_{mP1}$ and $g_{mP2}$ are transconductances of the transistors $MOSN_1$, $MOSN_2$, $MOSP_1$ and $MOSP_2$ respectively, and $g_{dN1}$, $g_{dN2}$, $g_{dP1}$ and $g_{dP2}$ are drain conductances of the transistors $MOSN_1$, $MOSN_2$, $MOSP_1$ and $MOSP_2$ respectively.

Here, the ratio between the gate length L and the gate width W for each of the field effect transistors $MOSP_1$, $MOSP_2$, $MOSN_1$ and $MOSN_2$ is set to satisfy Eqs. (5) and (6):

$$\frac{W_{P1}}{L_{P1}} = A \cdot \frac{W_{P2}}{L_{P2}} \tag{5}$$

$$\frac{W_{N1}}{L_{N1}} = A \cdot \frac{W_{N2}}{L_{N2}} \tag{6}$$

where A is a positive constant, $W_{P1}$ is the gate width of the transistor $MOSP_1$, $L_{P1}$ is the gate length of the transistor $MOSP_1$, $W_{P2}$, $W_{N1}$ and $W_{N2}$ are the respective gate widths of the transistors $MOSP_2$, $MOSN_1$ and $MOSN_2$, and $L_{P2}$, $L_{N1}$ and $L_{N2}$ are the respective gate lengths of the transistors $MOSP_2$, $MOSN_1$ and $MOSN_2$.

When Eqs. (5) and (6) are satisfied, since

$$g_{mP1} = A \cdot g_{mP2}, \, g_{mN1} = A \cdot g_{mN2} \tag{7}$$

$$g_{dP1} = A \cdot g_{dP2}, \, g_{dN1} = A \cdot g_{dN2} \tag{8}$$

it follows that the gain G of the inverter circuit 1 is given by Eq. (9):

$$G = - \frac{g_{mN1} \cdot g_{mP1}}{(g_{dN1} \cdot g_{dP1}) + \frac{1}{A} \cdot (g_{mN1} \cdot g_{mP1}) + \frac{1}{A} \cdot (g_{dN1} \cdot g_{dP1})}$$
$$= - \frac{1}{\frac{1}{|G1|} + \frac{1}{A} + \frac{1}{A \cdot |G1|}} \tag{9}$$

where G1 is the DC gain of the circuit shown in Fig. 1 with no gain control inverter section In2, that is, the DC gain of the inverter section In1 that includes no P type field effect transistor $MOSP_2$ and no N type field effect transistor $MOSN_2$, and is given by Eq (10):

$$G1 = - \frac{(g_{mN1} \cdot g_{mP1})}{(g_{dN1} \cdot g_{dP1})} \tag{10}$$

Therefore, if $A \ll |G1|$, it follows that $|G| \doteqdot A$. For example, if $|G1| = 20$ and $A = 1.5$, then $|G1| = 1.33$.

In the present embodiment, the corresponding transistors in the inverter section In1 used as an amplifier and in the inverter section In2 for controlling the gain of the inverter section In1 are arranged to be similar to each other so that all the size ratios equal the positive constant A ($A \ll |G1|$). However, there is an alternative. For example, the inverter sections In1 and In2 may be composed of a combination of P type and N type field effect transistors of a unit size. In this case, since the constant A satisfies the equation $1/A \doteqdot 1$, it follows that G (gain of the inverter circuit 1) $\doteqdot -1$.

The absolute value |G| of the DC gain G of an inverter is, typically, approximately between 10 and 30. However, as in the present embodiment, the absolute value |G| of the whole DC gain G of the inverter circuit 1 can be reduced, without being affected by irregularity in a manufacturing process, by connecting a gain control inverter (e.g., the inverter section In2 shown in Fig. 1) to an inverter (e.g., the inverter section In1 shown in Fig.1).

Incidentally, the above-mentioned prior art reference, "IEEE J. Solid-State Circuits, p. 1552-1559, vol. 29, No. 12, 1994", discloses an arrangement using only an N type field effect transistor $MOSN_2$ in the inverter section In2. In this case, the absolute value |G| of the gain G of the inverter circuit is given by Eq. (11):

$$|G| \fallingdotseq B + \sqrt{[(1+B) \cdot C]} \cdot \sqrt{\frac{\mu_P}{\mu_N}} \qquad (11)$$

where B and C are constants showing relations between the ratios of the gate length L and the gate width W of the field effect transistors $MOSP_1$, $MOSN_1$ and $MOSN_2$, and are defined as $B = (W_{N1}/L_{N1})/(W_{N2}/L_{N2})$ and $C = (W_{P1}/L_{P1})/(W_{N2}/L_{N2})$, and $\mu_P$ and $\mu_N$ are mobilities of holes and electrons respectively.

Therefore, the gain G of the inverter circuit is affected by the parameters $\mu_P$ and $\mu_N$ as expressed in Eq. (11). Since the parameters $\mu_P$ and $\mu_N$ depend upon a manufacturing process of the field effect transistor, when there is irregularity in a manufacturing process, the gain G is affected by that irregularity and varies.

By contrast, in the present embodiment, both a P type field effect transistor $MOSP_2$ and a N type field effect transistor $MOSN_2$ are used in the inverter section In2 as loads for controlling the gain as shown in Fig. 1. Consequently, the gain G of the inverter circuit 1 of the present embodiment is determined, as expressed in Eq. (9), by the constant A indicating the size ratios of the inverter sections In1 and In2 and the gain G1 of the inverter section In1. Especially, if $A<<|G1|$, then $|G| \fallingdotseq A$. Since the constant A is determined only by the size ratios of the field effect transistors $MOSN_1$, $MOSP_1$, $MOSN_2$ and $MOSP_2$, it is possible to completely eliminate affection by the parameters $\mu_P$ and $\mu_N$ varying depending upon manufacturing processes from the gain G of the inverter circuit 1.

[SECOND EMBODIMENT]

In the first embodiment, Eqs. (7) and (8) are assumed to be true based on approximation that no physical property parameters, such as the channel length conversion coefficient and threshold voltage, change with the size of a field effect transistor. But, in fact, these physical property parameters do change, if not greatly, with the size of a field effect transistor. As a result, it is difficult to precisely predict the gain of the circuit of the first embodiment. The second embodiment offers a solution for a more precise prediction.

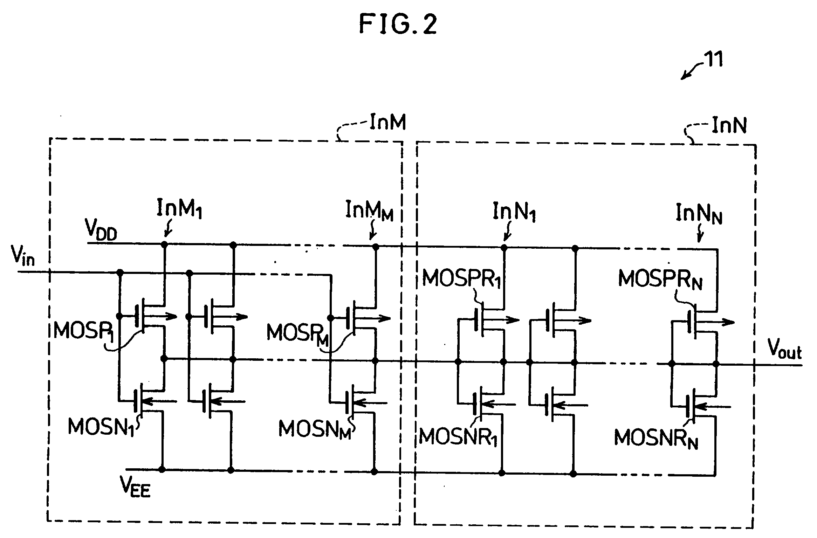

Referring to Fig. 2, the following description will explain the second embodiment in detail.

The inverter circuit 11 shown in Fig. 2 is composed of an inverter section InM used as an amplifier and an inverter section InN for controlling the gain. The inverter section InM is composed of a plurality (m pieces) of inverters $InM_1$ through $InM_M$ connected in parallel. The inverters $InM_1$ through $InM_M$ have almost the same arrangement as the inverter section In1 shown in Fig. 1. The inverter section InN is composed of a plurality (n pieces) of inverters $InN_1$ through $InN_N$ connected in parallel. The inverters $InN_1$ through $InN_N$ have almost the same arrangement as the inverter section In2 shown in Fig. 1. The inverters $InM_i$ and $InN_j$ ($1 \le i \le M$, $1 \le j \le N$) constituting the inverter sections InM and InN are composed of inverters of the same size or a similar size.

Fig. 2 shows an example in which each of the inverters $InM_i$ and $InN_j$ are composed of a single inverter. The P type field effect transistors $MOSP_1$ through $MOSP_M$ and $MOSPR_1$ through $MOSPR_N$ have the same size, are composed of so-called P type transistors of a unit size, and satisfy Eq. (12):

$$\frac{W_{P1}}{L_{P1}} = \frac{W_{P2}}{L_{P2}} = \ldots = \frac{W_{PM}}{L_{PM}} = \frac{W_{PR1}}{L_{PR1}} = \frac{W_{PR2}}{L_{PR2}} = \ldots = \frac{W_{PRN}}{L_{PRN}} \qquad (12)$$

The N type field effect transistors $MOSN_1$ through $MOSN_M$ and $MOSNR_1$ through $MOSNR_N$ are arranged in the same manner as above, and satisfy Eq. (13):

$$\frac{W_{N1}}{L_{N1}} = \frac{W_{N2}}{L_{N2}} = \ldots = \frac{W_{NM}}{L_{NM}} = \frac{W_{NR1}}{L_{NR1}} = \frac{W_{NR2}}{L_{NR2}} = \ldots = \frac{W_{NRN}}{L_{NRN}} \qquad (13)$$

Here, the DC gain G of the inverter circuit 11 of the circuit shown in Fig. 2 is given by Eq. (14):

$$G = -\frac{M \cdot (g_{mN1} - g_{mP1})}{M \cdot (g_{dN1} - g_{dP1}) + N \cdot (g_{mN1} - g_{mP1}) + N \cdot (g_{dN1} - g_{dP1})} \qquad (14)$$

$$= -\frac{1}{\frac{1}{|G1|} + \frac{N}{M} + \frac{N}{M \cdot |G1|}}$$

Since the inverter section InM used as an amplifier is composed of M pieces of single inverters simply connected in parallel, the gain of the inverter section InM is the same as in Eq. (10) and therefore is given as in Eq. (15):

$$G1 = - \frac{g_{mN1} - g_{mP1}}{g_{dN1} - g_{dP1}} \tag{15}$$

Consequently, if $M/N \ll |G1|$, it follows that $|G| \fallingdotseq M/N$. G1 varies depending upon irregularity in a manufacturing process, but M/N is not affected by irregularity in a manufacturing process. Therefore, the value of the DC gain G is little affected by irregularity in a manufacturing process, and it is possible to easily reduce the absolute value $|G|$ of the whole DC gain G of the inverter circuit 11 with the values of M and N. M and N may take any values: for example, if M = 5 and N = 2, then $|G| \fallingdotseq 2.5$.

In the above description, inverters of the same size are used as the inverters $InM_i$ and $InN_j$ constituting the respective inverter sections InM and InN. When the M pieces of inverters $InM_1$ through $InM_M$ connected in parallel and used as an amplifier are similar to the N pieces of inverters $InN_1$ through $InN_N$ connected in parallel and used for controlling the gain, the gain G of the inverter circuit 11 is given as follows.

It is assumed that the ratio of similitude is A. That is, it is assumed that:

$$\frac{W_{Pi}}{L_{Pi}} = A \cdot \frac{W_{PRj}}{L_{PRj}} \; ; (1 \leq i \leq M, 1 \leq j \leq N)$$

$$\frac{W_{Ni}}{L_{Ni}} = A \cdot \frac{W_{NRj}}{L_{NRj}} \; ; (1 \leq i \leq M, 1 \leq j \leq N)$$

where $W_{Pi}$ and $L_{Pi}$ are the channel width and length of $MOSP_i$ respectively, $W_{PRj}$ and $L_{PRj}$ are the channel width and length of $MOSPR_j$ respectively, $W_{Ni}$ and $L_{Ni}$ are the channel width and length of $MOSN_i$ respectively, and $W_{NRj}$ and $L_{NRj}$ are the channel width and length of $MOSNR_j$ respectively. Here, the DC gain G of the inverter circuit 11 shown in Fig. 2 is given by Eq. (16):

$$G = - \frac{1}{\frac{1}{|G1|} + \frac{N}{A \cdot M} + \frac{N}{A \cdot M \cdot |G1|}} \tag{16}$$

Therefore, if $A \cdot M/N \ll |G1|$, then $|G| \fallingdotseq A \cdot M/N$.

Due to constraints in a manufacturing process, it is difficult to control the value of the gain in the previous embodiment, that is, an embodiment for attempting to control the gain with a single pair of inverters of the ratio of similitude A. However, such control can be easily realized by combining a plurality of similar inverters in the above manner and by selecting appropriate M and N. For example, if A = 2, M =2, and N = 1, then $|G| \fallingdotseq 4$.

Fig. 3 shows an amplifier composed of a plurality of inverter circuits connected in series. An odd number of inverter circuits (three inverter circuits INV1, INV2 and INV3 in Fig. 3) are connected in series to form an inversion amplifier as an example. Here, at least one of the three inverter circuits INV1, INV2 and INV3 is an inverter circuit 1(11) that includes the inverter section In2 (InN) for controlling the gain explained in the first and second embodiments.

An amplifier 21 arranged in this manner is used for a signal processing circuit by applying a negative feedback as an inversion amplifier as shown in Fig. 3. The absolute value of the whole gain is large, because it equals the product of the absolute values of the gains of the inverter circuits connected in series (e.g., the three inverter circuits shown in Fig. 3). Therefore, when a negative feedback is applied, the phase margin becomes small, which may cause unstable operation and oscillation.

Here, by replacing at least one of the inverter circuits INVs (X pieces in all) of the amplifier 21 with an inverter circuit 1(11) that includes the inverter section In2 (InN) for controlling the gain described in the above embodiments, the absolute value of the whole gain of the amplifier 21 can be controlled so as to be the largest in a range where a stable feedback is possible. This can effectively improve, especially, the frequency characteristics that is a problem with an inversion amplifier composed of an odd number of inverter circuits connected in series. Such an improvement is made equally in the first and second embodiments.

Note that the present invention can be applied to a circuit using a pair of inverters that is not exactly similar but almost similar, instead of a pair of similar inverters. In this case, it becomes a little difficult to precisely predict the gain as an amplifier. However, other expected results are achieved, including little variation against irregularity in a process, a smaller power consumption, a smaller area occupied by the circuit, and a smaller parasitic capacity.

As described so far, the inverter circuit (1) of the first embodiment is characterized in that it includes a first inverter section (In1) used as an amplifier and a second inverter section (In2) for controlling the gain of the first inverter section, the second inverter section being connected in series to the first inverter section, being composed of CMOS field effect transistors ($MOSN_2$ and $MOSP_2$) of a similar size to CMOS field effect transistors ($MOSN_1$ and $MOSP_1$) of the first inverter section, and being short-circuited between an input terminal thereof and an output terminal thereof.

With the arrangement, (i) the second inverter section operates equivalently to a resistor connected to an output terminal of the first inverter section, thereby reducing the gain of the first inverter section to a desired value, (ii) the CMOS field effect transistors of the first and second inverter sections, being of similar sizes to each other, allow both the inverter sections to change the characteristics thereof in the same tendency when there is irregularity in a manufacturing process of a large scale integrated (LSI) circuit, (iii) the sizes of the CMOS field effect transistors can be easily controlled by controlling the gate length and width of the field effect transistors composing the CMOS inverters. Consequently, an inverter circuit with a DC gain very close to a designed value can be made in an integrated circuit, regardless of possible irregularity in a manufacturing process of an LSI.

Such an inverter circuit has advantages, in comparison with a conventional inverter circuit using resistors for controlling the gain. For example, the inverter circuit (i) occupies a smaller area, because the field effect transistors are used instead of the resistors, (ii) has better frequency characteristics, because the parasitic capacity is reduced, and (iii) consumes less power, because the second inverter section has a CMOS structure which allows no electric current to flow as long as there is no change in the output. For a more precise control of the gain of the inverter circuit, the MOS field effect transistors of the first inverter section (In1) used as an amplifier and of the second inverter section (In2) for controlling the gain of the first inverter section are preferably composed of a combination of P type and N type field effect transistors of a unit size.

With the arrangement, since the field effect transistors are composed in a unit size, the field effect transistors composing the first inverter section have the same physical property parameters (e.g., the channel length conversion coefficient and threshold voltage) as those composing the second inverter section. As a result, the irregularity of the gain of the inverter circuit caused by irregularity in a manufacturing process can be more reduced than in a case where the field effect transistors composing the first and second inverter sections are similar with a ratio of similitude not equal to 1.

Incidentally, when each of the first and second inverter sections is composed of a single MOS field effect transistor, constraints in a manufacturing process limit the gain of the first inverter section and the size ratio (ratio of similitude) of the field effect transistors of both the inverter sections. Therefore, the gain and precision of the inverter circuit may not be set as desired. Especially, when the ratio of similitude equals 1, the gain of the inverter circuit is limited to approximately 1.

When the inverter circuit (1) having one of the above arrangements cannot produce a gain or precision as desired, the inverter circuit (11) preferably includes, as explained in the second embodiment, the following arrangement. That is, the inverter circuit preferably includes a first inverter section (InM) used as an amplifier and a second inverter section for controlling the gain of the first inverter section, the first inverter section (InM) being composed of parallelly connected M pieces of inverters ($InM_1$ through $InM_M$) including CMOS field effect transistors, the second inverter section being connected in series to the first inverter section and being composed of parallelly connected N pieces of inverters ($InN_1$ through $InN_N$) that include CMOS field effect transistors of a similar size to those of the first inverter section and that are short-circuited between input and output terminals thereof. M and N are positive integral numbers, at least one of which is set to be larger than 1.

With the arrangement, the gain of the inverter circuit is controlled with the ratio of the number of inverters (M pieces) composing the first inverter section and the number of inverters (N pieces) composing the second inverter section. Therefore, the gain can be controlled to have a value which is difficult to realize due to constraints in a manufacturing process if each of the first and second inverter sections is composed of a single inverter.

When at least one of the first and second inverter sections is composed of a plurality of inverters, the inverter circuit preferably includes the following arrangement. That is, the inverter circuit preferably includes P type and N type field effect transistors ($MOSN_1$ through $MOSN_M$, $MOSP_1$ through $MOSP_M$, $MOSNR_1$ through $MOSNR_N$ and $MOSPR_1$ through $MOSPR_N$) of a unit size as the MOS field effect transistors of the first inverter section (InM) used as an amplifier and of the second inverter section (InN) for controlling the gain of the first inverter section. This arrangement can more freely set the gain of the inverter circuit than the inverter sections composed of a single inverter, and can more precisely control the gain of the inverter circuit than in a case where the ratio of similitude is set to a value other than 1.

Incidentally, a typical preferred application example of the inverter circuit is the amplifier (21), shown in Fig. 3, composed of a plurality of the inverter circuits (INV1 through INV3) connected in series. In this case, at least one of the inverter circuits composing the amplifier is preferably an inverter circuit having one of the above arrangements (hereinafter, will be referred to as a special inverter circuit).

With the arrangement, the gain of the amplifier equals the product of the gains of the inverter circuits. Therefore, an amplifier with a very large gain which is difficult to realize with a single inverter circuit can be easily made. Moreover, since at least one of the inverter circuits includes the gain control second inverter section (In2, InN), the gain of such an amplifier can be more precisely set than that of a conventional amplifier.

An odd number of inverter circuits (INV1 through INV3) are preferably connected in series to form an inversion amplifier. With the arrangement, since at least one of the inverter circuits is a special inverter circuit, the gain of the inversion amplifier can be precisely controlled. Therefore, when an output of the inversion amplifier is fed back negatively to an input, the gain of the inversion amplifier can be set so as to be the largest in a range where a stable feedback is possible. As a result, the frequency characteristics of the inversion amplifier can be effectively improved.

The invention being thus described, it will be obvious that the same may be varied in many ways. Such variations are not to be regarded as a departure from the spirit and scope of the invention, and all such modifications as would be obvious to one skilled in the art intended to be included within the scope of the following claims.

## Claims

1. An inverter circuit for inverting an input and outputting the inverted input, comprising:

   a first inverter section including a first CMOS inverter composed of P type and N type field effect transistors connected in a CMOS structure; and
   a second inverter section including a second CMOS inverter and being connected in series to an output terminal of the first inverter section, the second CMOS inverter being of a similar size to the first CMOS inverter and being short-circuited between an input terminal thereof and an output terminal thereof.

2. The inverter circuit as defined in claim 1,
   wherein the field effect transistors composing the first and second CMOS inverters are field effect transistors of a unit size.

3. The inverter circuit as defined in claim 1,
   wherein the first inverter section includes more than one first CMOS inverter connected in parallel to each other.

4. The inverter circuit as defined in claim 1,
   wherein the second inverter section includes more than one second CMOS inverter connected in parallel to each other.

5. The inverter circuit as defined in claim 2,
   wherein the first inverter section includes more than one first CMOS inverter connected in parallel to each other.

6. The inverter circuit as defined in claim 2,
   wherein the second inverter section includes more than one second CMOS inverter connected in parallel to each other.

7. An amplifier, comprising inverter circuits connected in series to each other,
   wherein at least one of the inverter circuits includes:

   a first inverter section including a first CMOS inverter composed of P type and N type field effect transistors connected in a CMOS structure; and
   a second inverter section including a second CMOS inverter and being connected in series to an output terminal of the first inverter section, the second CMOS inverter being of a similar size to the first CMOS inverter and being short-circuited between an input terminal thereof and an output terminal thereof.

8. The amplifier as defined in claim 7,
   wherein the inverter circuits are provided in an odd number.

# FIG.1

FIG.2

EP 0 797 303 A2

FIG.3

INV1    INV2    INV3        ⟋21

INPUT ─▷○─────▷○─────▷○─ OUTPUT

FIG.4

51↘

V_DD

MOSP

V_in ──── V_out

MOSN

V_EE

FIG.5

61↘

V_DD

MOSP    i    R1

V_in ──── V_out

MOSN    R2

V_EE

12